# DEMANDE DE BREVET EUROPEEN

(11) **EP 4 060 716 A1**
(43) Date de publication de la demande: **21.09.2022**
(21) Numéro de dépôt: 22161365.6
(22) Date de dépôt: 10.03.2022
(51) Int. Cl.: H01L 21/268

(54) **PROCEDE DE MODIFICATION D'UN ETAT DE CONTRAINTE D'AU MOINS UNE COUCHE SEMI-CONDUCTRICE**

(30) Priorité: 15.03.2021 FR 2102523
(71) Demandeur: Commissariat à l'énergie atomique et aux énergies alternatives, 75015 Paris (FR)
(72) Inventeur: REBOH, Shay, 38054 GRENOBLE Cedex 09 (FR); ACOSTA ALBA, Pablo, 38054 GRENOBLE CEDEX 09 (FR)
(74) Mandataire: Brevalex

(57) **Abrégé**

Le procédé de modification d'un état de contrainte d'au moins une couche (104) semi-conductrice comporte une étape de fourniture d'un support (100) sur lequel est agencé au moins un empilement de couches comportant la couche (104) semi-conductrice et une couche (102) fusible, agencée entre la couche (104) semi-conductrice et le support (102), le procédé de modification comportant une étape de fusion d'au moins une partie de la couche (104) fusible, en particulier à l'aide d'un faisceau laser afin de provoquer la modification de l'état de contrainte de la couche (104) semi-conductrice, l'étape de fusion comportant le passage de ladite au moins une partie de la couche (104) fusible d'un état solide à un état liquide, la couche (104) semi-conductrice restant à l'état solide durant l'étape (E2) de fusion.

## Description

### DOMAINE TECHNIQUE ET ART ANTERIEUR

La présente demande se rapporte au domaine de la microélectronique et, plus particulièrement, à celui des procédés permettant de déformer ou contraindre mécaniquement une couche semi-conductrice.

Par déformation mécanique d'une couche semi-conductrice on entend que son matériau a son ou ses paramètre(s) de maille cristalline allongé(s) ou écourté(s).

Dans le cas où le paramètre de maille déformé est plus important que le paramètre dit « naturel » d'un matériau cristallin, celui-ci est dit en déformation en tension. Lorsque le paramètre de maille déformé est plus petit que le paramètre de maille naturel, le matériau est dit en déformation compressive ou en compression.

A ces états de déformation mécanique, on associe des états de contraintes mécaniques. Pour autant, il est également commun de se référer à ces états de déformation comme des états de contraintes mécaniques. Dans la suite de la présente demande, cette notion de déformation (« strain » selon la terminologie anglo-saxonne) sera désignée de façon générique par le terme « contrainte ».

Une contrainte appliquée à un matériau semi-conducteur induit une modification de la maille cristalline et donc de sa structure de bande, dont va découler une modification de la mobilité des porteurs dans ce matériau.

La mobilité des électrons est augmentée (respectivement diminuée) par une contrainte en tension (respectivement en compression) du matériau semi-conducteur dans lequel ils transitent alors que la mobilité des trous sera augmentée (respectivement diminuée) lorsque le semi-conducteur est en compression (respectivement en tension).

Ainsi, pour améliorer les performances des transistors, on peut prévoir de réaliser leur région de canal dans un matériau semi-conducteur ayant une contrainte mécanique en tension ou en compression.

Le document US 2008/0169508 A1 propose un procédé de fabrication d'un substrat semi-conducteur sur isolant comportant une couche de silicium que l'on souhaite contraindre et une couche isolante à base de verre de silicate dopé. Une couche sacrificielle donneuse contrainte en nitrure de silicium est déposée sur la couche de silicium, puis des tranchées sont réalisées de manière à permettre un transfert de contrainte dans la couche semi-conductrice. Ensuite, on fait fluer la couche de verre de silicate dopé d'où il résulte une modification de la couche sacrificielle, de la couche de silicium.

Ici, les dopants utilisés au sein de la couche isolante sont nécessaires pour permettre de réaliser ce fluage.

Un inconvénient de cette solution est donc qu'elle nécessite d'apporter des dopants comme le bore et le phosphore dans la couche d'oxyde enterré. De tels dopants peuvent alors diffuser de la couche d'oxyde enterré vers la couche de silicium, ce qui peut être néfaste pour former le canal d'un transistor.

Un autre inconvénient de cette solution est qu'elle est limitée aux substrats de type semi-conducteur sur isolant.

Un autre inconvénient de cette solution est également que des recuits utérieurs ayant une température supérieure à la température de fluage de la couche de verre sont susceptibles d'entrainer unemodification non contrôlée de l'état de contrainte de la couche contrainte.

Plus généralement, il se pose le problème de trouver un nouveau procédé de modification de l'état de contrainte d'une couche semi-conductrice.

### EXPOSE DE L'INVENTION

L'invention a pour but de permettre une modification d'un état de contrainte d'une couche semi-conductrice, de préférence destinée à être utilisée dans le cadre de la fabrication d'un dispositif microélectronique comme par exemple un transistor.

À cet effet, selon un aspect, la présente invention est relative à un procédé de modification d'un état de contrainte d'au moins une couche semi-conductrice, le procédé de modification comportant une étape de fourniture d'un support sur lequel est agencé au moins un empilement de couches comportant la couche semi-conductrice et une couche dite « fusible », la couche fusible étant agencée entre la couche semi-conductrice et le support. Ce procédé de modification comporte une étape de traitement thermique de sorte à réaliser la fusion d'au moins une région de la couche fusible, afin de provoquer la modification de l'état de contrainte de la couche semi-conductrice, l'étape de fusion comportant le passage transitoire de ladite au moins une région de la couche fusible d'un état solide à un état liquide, au moins une épaisseur de la couche semi-conductrice restant à l'état solide durant l'étape de fusion.

Le traitement thermique est typiquement réalisé à l'aide d'un faisceau laser. L'utilisation du laser permet une élévation thermique rapide et élevée de l'empilement de couches.

De manière particulièrement avantageuse, la couche fusible est en matériau semi-conducteur, de préférence non-dopé. Dans ce cas, la couche fusible n'a subi aucune étape de dopage préalablement au traitement thermique pour réaliser la fusion.

Ainsi, un mode de réalisation de la présente invention concerne un procédé de modification de l'état de contrainte d'au moins une couche semi-conductrice comprenant des étapes de :
a) réalisation sur un support d'au moins un empilement de couches comportant ladite couche semi-conductrice en un premier matériau semi-conducteur et une couche fusible, ladite couche fusible étant prévue à base d'un deuxième matériau semi-conducteur distinct du premier matériau semi-conducteur, ladite couche fusible étant agencée entre la couche semi-conductrice et le support, puis,
b) traitement thermique, en particulier un traitement thermique rapide, de sorte à provoquer un passage transitoire d'au moins une épaisseur de la couche fusible dans ledit empilement d'un état solide à un état liquide tout en conservant au moins une épaisseur de la couche semi-conductrice à l'état solide.

On induit, par le biais de ce traitement thermique, une modification de l'état de contrainte de la couche semi-conductrice.

Au terme de l'étape de traitement thermique, une solidification de ladite au moins une épaisseur de la couche fusible est réalisée, l'état de contrainte de la couche semi-conductrice étant alors différent de l'état de contrainte de la couche semi-conductrice avant la mise en œuvre de l'étape de traitement thermique et la fusion de la couche fusible.

L'au moins une épaisseur de la couche semi-conductrice conservée à l'état solide est celle se trouvant en contact avec la couche donneuse de contrainte ou du côté de la couche donneuse.

Typiquement, le traitement thermique est effectué à l'aide d'un laser, en particulier en soumettant l'empilement à une ou plusieurs impulsions laser. Au terme de l'étape de traitement laser, le retour dans un état solide de la couche fusible permet de figer la contrainte dans couche semi-conductrice.

L'utilisation d'un laser permet une élévation thermique rapide de l'empilement de couches à une température prédéterminée autorisant la fusion de la couche fusible et la modification de contrainte dans la couche semi-conductrice telle qu'évoquée précédemment tout en évitant une diffusion intempestive d'atomes dans l'empilement tout en limitant le budget thermique employé. Un autre avantage d'un tel type de traitement est que l'utilisation du faisceau laser permet la modification de l'état de contrainte de manière ciblée spatialement.

Avantageusement, l'étape de traitement thermique est effectuée à l'aide d'un laser par émission d'une ou de plusieurs impulsions laser successives, de durée de chaque impulsion inférieure à une microseconde et de préférence comprise entre 10 ns et 1000 ns, avantageusement entre 20 ns et 500 ns, le laser ayant une longueur d'onde typiquement comprise entre 100 nm et 550 nm et de préférence entre 250 nm et 400 nm.

La réalisation dudit empilement peut comprendre des étapes de :
- formation d'une superposition de couches sur ledit support comprenant ladite couche fusible, ladite couche semi-conductrice et une couche donneuse de contrainte, la couche donneuse de contrainte étant à base d'un matériau présentant une contrainte intrinsèque prédéterminée, en tension ou en compression,
- gravure de ladite superposition de sorte à définir ledit au moins un empilement et délimiter des bords latéraux de la couche donneuse de contrainte et de la couche semi-conductrice.

Une telle couche donneuse de contrainte peut permettre d'appliquer une contrainte dans la couche semi-conductrice, la gravure permettant de structurer l'empilement et de favoriser le transfert de contrainte dans la couche semi-conductrice.

Lorsque la couche donneuse est compressive, un étirement de la couche semi-conductrice est réalisée, tandis que lorsque la couche donneuse est en tension (tensile), une compression de la couche semi-conductrice est mise en œuvre.

Selon une mise en œuvre particulière, la couche donneuse de contrainte est en nitrure de silicium.

Selon une possibilité de mise en œuvre du procédé, dans la superposition de couches, la couche semi-conductrice peut être agencée entre la couche fusible et la couche donneuse de contrainte.

Selon une variante avantageuse, la couche donneuse de contrainte peut être agencée entre la couche fusible et la couche semi-conductrice. Lorsque la couche donneuse de contrainte est en un matériau amorphe et non susceptible d'être recristallisée, par exemple en un matériau isolant, le fait d'avoir une couche donneuse de contrainte agencée entre la couche fusible et la couche semi-conductrice, permet d'éviter un transfert de dislocations de la couche fusible vers la couche semi-conductrice.

Ainsi, plus généralement, pour éviter un tel transfert de dislocations on peut avantageusement prévoir une couche intermédiaire amorphe et typiquement en un matériau isolant entre la couche fusible et la couche semi-conductrice dont on souhaite modifier l'état de contrainte.

Selon une autre possibilité de mise en œuvre, la couche donneuse de contrainte est disposée au-dessus de la couche semi-conductrice et la superposition de couches comporte une couche additionnelle donneuse de contrainte disposée au-dessous de la couche semi-conductrice. Dans ce cas, on peut ainsi avantageusement accroitre le transfert de contrainte.

Le deuxième matériau et le premier matériau sont typiquement prévus de sorte à passer à l'état liquide à une température inférieure à celle à laquelle le premier matériau est susceptible de passer à l'état liquide.

Avantageusement, le deuxième matériau semi-conducteur a une température de fusion ou de liquidus inférieure à la température de fusion ou de liquidus dudit premier matériau semi-conducteur.

Ainsi, lorsque le deuxième matériau semi-conducteur est un corps pur, le deuxième matériau semi-conducteur a une température de fusion inférieure à la température de fusion dudit premier matériau semi-conducteur lorsque le premier matériau semi-conducteur est un corps pur ou inférieure à la température de liquidus dudit premier matériau semi-conducteur lorsque ce dernier est un composé semi-conducteur (encore appelé alliage).

Lorsque le deuxième matériau semi-conducteur est un composé semi-conducteur, le deuxième matériau semi-conducteur a une température de liquidus inférieure à la température de fusion dudit premier matériau semi-conducteur lorsque le premier matériau semi-conducteur est un corps pur ou inférieure à la température de liquidus dudit premier matériau semi-conducteur lorsque ce dernier est un composé semi-conducteur.

Avantageusement, la couche fusible est disposée sur une couche superficielle du support en un matériau donné ayant une température de fusion supérieure à la température de fusion ou de liquidus du deuxième matériau semi-conducteur, de sorte que lors du traitement thermique, ladite couche superficielle reste à l'état solide. Ainsi, tandis qu'on réalise une fusion de la couche fusible, le support est maintenu dans un état solide.

Avantageusement, le support peut être un substrat massif semi-conducteur, la couche fusible étant disposée sur le substrat massif semi-conducteur.

Selon une autre possibilité de mise en œuvre, la couche fusible est disposée sur une couche isolante d'un substrat de type semi-conducteur sur isolant, la couche isolante étant en particulier en oxyde de silicium.

De manière avantageuse, l'empilement peut être tel que :
- le premier matériau semi-conducteur est du silicium et le deuxième matériau semi-conducteur du silicium-germanium ou du germanium,
   ou
- le premier matériau semi-conducteur est du silicium-germanium et le deuxième matériau semi-conducteur du silicium-germanium, de concentration en pourcentage atomique du germanium supérieure à la concentration en pourcentage atomique du germanium du premier matériau,
   ou
- le premier matériau est formé de germanium et le deuxième matériau est formé de germanium-étain,
   ou
- le premier matériau semi-conducteur est cristallin, le deuxième matériau semi-conducteur est amorphe.

Dans l'empilement, lorsque le premier matériau semi-conducteur est cristallin, la réalisation de l'empilement peut comprendre au moins une implantation ionique de sorte à rendre amorphe le matériau de la couche fusible. La mise dans un état amorphe du deuxième matériau semi-conducteur peut permettre de réduire la température à laquelle ce matériau peut être mis dans un état liquide.

Avantageusement, le traitement thermique pour réaliser la fusion est prévu de sorte à :
- chauffer ladite épaisseur de la couche fusible à une température supérieure ou égale à une température de fusion du deuxième matériau semi-conducteur et supérieure ou égale à une température du liquidus de la couche fusible lorsque la couche fusible est formée par un composé semi-conducteur, tout en conservant au moins une épaisseur de la couche semi-conductrice à une température inférieure à une température de fusion du premier matériau semi-conducteur et inférieure à une température du solidus du premier matériau semi-conducteur lorsque la couche semi-conductrice est formée par un autre composé semi-conducteur.

La couche fusible dans l'empilement peut être dépourvue de dopants. Ainsi, de préférence la réalisation de l'empilement ne comporte pas d'étape de dopage. Lors du traitement thermique conduisant à la fusion on évite ainsi une diffusion intempestive de dopants.

L'empilement peut comporter une couche donneuse de contrainte ayant une contrainte intrinsèque en tension et le procédé peut comprendre la formation sur le support, à partir de ladite superposition de couches, d'un autre empilement surmonté d'une autre une couche donneuse de contrainte, à base d'un matériau présentant une contrainte intrinsèque en compression.

Selon un autre aspect, la présente invention concerne un procédé de fabrication d'un transistor comprenant la mise en œuvre d'un procédé de modification tel que défini plus haut, le transistor ayant une région de canal réalisée dans la couche semi-conductrice dont la contrainte est modifiée.

Procédé de mise en contrainte d'au moins une couche semi-conductrice comprenant des étapes de :
a) réalisation sur un support d'au moins un empilement de couches comportant ladite couche semi-conductrice en un premier matériau semi-conducteur et une couche dite « fusible », ladite couche fusible étant prévue à base d'un deuxième matériau semi-conducteur, distinct du premier matériau semi-conducteur, ladite couche fusible étant dépourvue de dopants et étant agencée entre la couche semi-conductrice et le support, ladite superposition de couches comprenant en outre une couche donneuse de contrainte,
   puis,
b) traitement thermique rapide à l'aide d'un laser, dudit empilement et particulièrement de la couche fusible, de sorte à provoquer un passage transitoire d'au moins une épaisseur de la couche fusible d'un état solide à un état liquide tout en conservant au moins une épaisseur de la couche semi-conductrice à l'état solide, et autoriser un transfert de contrainte dans la couche semi-conductrice.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
Les figures 1A, 1B, 1C, 1D servent à illustrer des étapes d'un exemple de procédé de modification de l'état de contrainte d'une couche semi-conductrice dans un empilement comprenant une couche fusible que l'on rend liquide de manière transitoire ;
La figure 2 sert à illustrer une variante d'empilement à partir duquel des étapes d'un procédé, suivant l'invention, de modification de l'état de contrainte d'une couche semi-conductrice peuvent être mis en œuvre ;
La figure 3 sert à illustrer une autre variante dudit empilement dans laquelle une couche intercalaire est prévue entre la couche fusible et la couche semi-conductrice dont on souhaite modifier la contrainte ;
La figure 4 sert à illustrer une autre variante dudit empilement dans laquelle une couche donneuse de contrainte est cette fois prévue sous la couche semi-conductrice dont on souhaite modifier la contrainte et sur la couche fusible ;
La figure 5 sert à illustrer une autre variante dudit empilement dans laquelle plusieurs couches intercalaires sont prévues entre la couche semi-conductrice dont on souhaite modifier la contrainte et la couche fusible ;
La figure 6 sert à illustrer une autre variante dudit empilement dans laquelle une couche intercalaire est prévue entre la couche semi-conductrice dont on souhaite modifier la contrainte et une couche donneuse de contrainte sous-jacente ;
La figure 7 sert à illustrer une autre variante dudit empilement avec une couche donneuse de contrainte sur la couche semi-conductrice et une couche donneuse de contrainte supplémentaire sous-jacente ;
La figure 8 sert à illustrer une autre variante dans laquelle on effectue le traitement laser pour rendre liquide une couche fusible dans plusieurs empilements distincts chacun doté d'une couche semi-conductrice dont on souhaite modifier la contrainte ;
La figure 9 sert à illustrer une autre variante dans laquelle la couche fusible est également structurée avant d'effectuer le traitement laser pour rendre liquide cette dernière ;
La figure 10 sert à illustrer une autre variante dans laquelle la structuration de l'empilement est prolongée dans une couche superficielle du substrat servant de support à la couche fusible ;
La figure 11 sert à illustrer une autre variante dans laquelle on effectue un traitement laser pour rendre une région de la couche fusible liquide tout en préservant de l'exposition au laser une zone adjacente afin de la conserver non-liquide ;
La figure 12 sert à illustrer une autre variante dans laquelle on effectue le traitement laser permettant une modification de contrainte sur des empilements distincts dotés de couches donneuses de contrainte ayant des contraintes intrinsèques de types différents ;
La figure 13 sert à illustrer une autre variante dans laquelle on effectue un traitement laser permettant une modification de contrainte d'une couche semi-conductrice contrainte ;
La figure 14 sert à illustrer une amorphisation de la couche fusible semi-conductrice par implantation ionique afin d'abaisser la température à laquelle cette couche est ensuite susceptible d'être rendue au moins partiellement liquide ;
La figure 15 sert à illustrer une réalisation d'un transistor à partir d'une structure obtenue à l'issue d'un procédé de modification de contrainte d'une couche semi-conductrice tel que mis en œuvre suivant un mode de réalisation de la présente invention ;
Les figures 16A et 16B servent à illustrer des variantes de réalisation.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme pour rendre les figures plus lisibles.

En outre, dans la description ci-après, des termes qui dépendent de l'orientation, telle que « sur », « au-dessus », « supérieure », « latérale » etc. d'une structure s'appliquent en considérant que la structure est orientée de la façon illustrée sur les figures.

### EXPOSÉ DÉTAILLÉ DE MODES DE RÉALISATION PARTICULIERS

Un exemple de procédé suivant l'invention, permettant de modifier l'état de contrainte d'une couche semi-conductrice 104, va à présent être donné.

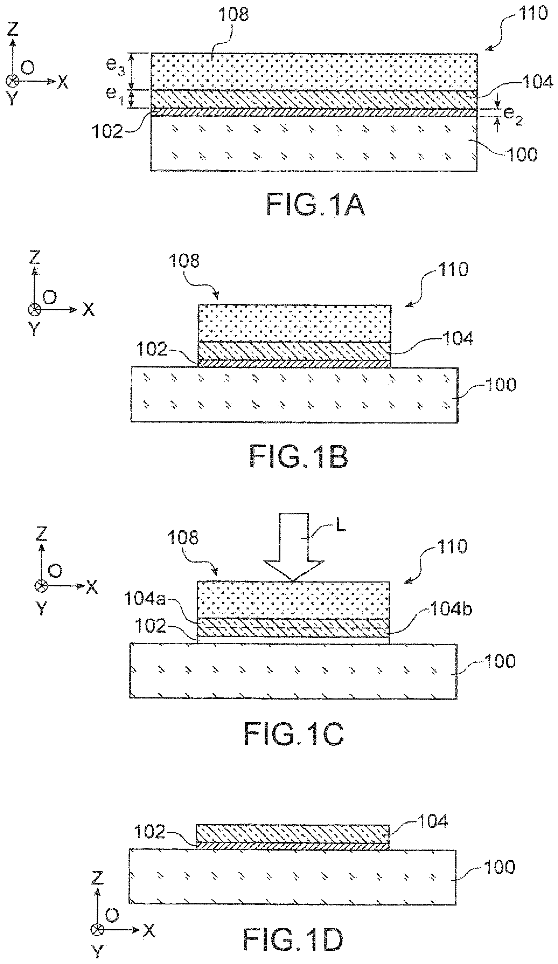

Le matériau de départ peut être, comme dans l'exemple illustré sur la figure 1A, un substrat 100 massif (« bulk » selon la terminologie anglo-saxonne), par exemple en silicium, servant de support à une superposition de couches.

La superposition de couches comporte une couche 102 dite « fusible » et la couche semi-conductrice 104 dans laquelle on souhaite opérer une modification de contrainte, c'est-à-dire mettre en contrainte ou augmenter la contrainte, ou effectuer une relaxation.

La couche semi-conductrice 104 est prévue en un premier matériau semi-conducteur, par exemple du silicium (Si), tandis que la couche fusible 102, est à base d'un deuxième matériau semi-conducteur, différent du premier matériau semi-conducteur.

Le premier matériau semi-conducteur et le deuxième matériau semi-conducteur peuvent être avantageusement choisis en fonction de leurs températures de fusion ou de liquidus respectives.

Ainsi, de préférence, le deuxième matériau semi-conducteur a une température de fusion inférieure à la température de fusion du premier matériau semi-conducteur dans le cas où ces deux matériaux sont des corps purs, le premier matériau semi-conducteur étant par exemple du silicium et le deuxième matériau semi-conducteur étant par exemple du germanium.

Avantageusement, le deuxième matériau semi-conducteur a une température de liquidus inférieure à la température de fusion du deuxième matériau semi-conducteur dans un autre cas où, le premier matériau semi-conducteur est par exemple un composé semi-conducteur également appelé alliage semi-conducteur tel que du silicium-germanium et le deuxième matériau semi-conducteur un corps pur tel que du germanium.

Avantageusement, le deuxième matériau semi-conducteur a une température de liquidus inférieure à la température de liquidus du premier matériau semi-conducteur dans un autre cas où, le premier matériau semi-conducteur est par exemple un composé semi-conducteur (également appelé alliage semi-conducteur) tel que du silicium-germanium et le deuxième matériau semi-conducteur un autre composé semi-conducteur tel que du silicium-germanium de composition différente, avec une en particulier une concentration en Germanium plus élevée.

Par exemple, le deuxième matériau semi-conducteur peut être à base de Germanium ou de Silicium Germanium (Si_{1-y}Ge_{y}). On prévoit dans ce cas une concentration y en Ge typiquement comprise entre 0.2 et 0.99, avantageusement entre 30 et 70% et plus particulièrement entre 40 et 60%, par exemple telle que y=0.6.

Les couches 102, 104 peuvent être réalisées par exemple par épitaxies successives, de préférence sans dopage du premier et du deuxième matériau semi-conducteurs. La couche 102 fusible est, dans l'exemple illustré, agencée en contact sur le substrat 100 et est revêtue par, et se trouve en contact avec, la couche semi-conductrice 104.

L'épaisseur e₂ de la couche 102 fusible (dimension mesurée parallèlement à la direction de l'axe z d'un repère orthogonal [O ;x ;y ;z]) peut être quant à elle avantageusement prévue avec une épaisseur inférieure à son épaisseur critique de relaxation plastique telle que notamment définie dans le document « Critical thickness for plastic relaxation of SiGe on Si(001) revisited » de J.M Hartmann et al. publié dans Journal of Applied Physics 110, 083529 (2011) en particulier lorsqu'elle est en silicium germanium et que le support 100 est formé de silicium. On évite ainsi la formation de dislocations dans la couche semi-conductrice 104 lors de la croissance. La couche fusible 102 peut être prévue avec une épaisseur e₂ comprise par exemple entre 5 et 100 nm.

La couche semi-conductrice 104 peut être prévue avec une épaisseur e₁ comprise par exemple entre 5 nm et 150 nm, avantageusement entre 5 et 50 nm.

Pour apporter une contrainte dans la couche semi-conductrice 104 on utilise dans cet exemple une couche dite « donneuse de contrainte » dans la superposition de couches. Cette couche 108 donneuse de contrainte est à base d'un matériau présentant une contrainte intrinsèque prédéterminée, en tension ou en compression. La couche donneuse de contrainte a de préférence une contrainte intrinsèque élevée typiquement comprise entre -8 GPa et 8 Gpa (et typiquement entre - 2.5 et 2.5 GPa). Le matériau de la couche donneuse de contrainte est de préférence choisi de manière à lui conférer un module élastique de l'ordre de grandeur ou encore de préférence plus élevé que celui de la couche semi-conductrice 104. Le matériau de la couche 108 donneuse de contrainte est également choisi de manière à être doté d'une structure stable à une température d'un traitement thermique destiné à être effectué ultérieurement sur la couche 102 fusible afin de mettre au moins une épaisseur de cette dernière dans un état liquide.

Ainsi, le matériau de la couche 108 donneuse de contrainte est de préférence choisi de manière à ne pas devenir liquide ou visqueux et conserver un niveau de contrainte élevé, pendant le procédé de mise en contrainte de la couche semi-conductrice 104 et en particulier suite au budget thermique imposé pour permettre la fusion du deuxième matériau semi-conducteur.

La couche 108 donneuse de contrainte est par exemple en nitrure de silicium (SiN), matériau que l'Homme du Métier sait obtenir avec une contrainte intrinsèque en compression ou bien en tension et par exemple comprise entre -3 Gpa et + 1.5 Gpa. Par ailleurs, la température de fusion du nitrure de silicium est de l'ordre de 1900°C, et donc strictement supérieure à celle du silicium et de la plupart des semi-conducteurs utilisés. Cela facilite le maintien de la couche 108 donneuse de contrainte à l'état solide lors de l'étape précitée de traitement thermique destinée à être réalisée ultérieurement.

Dans le cas particulier d'une couche semi-conductrice 104 épaisse, en particulier d'épaisseur supérieure à 15 nm, un autre avantage du nitrure de silicium est sa faible absorbance à la longueur d'onde des lasers UV, et en particulier sa transparence à la longueur d'onde d'un laser susceptible d'être utilisé par la suite pour effectuer le traitement thermique précité et permettre d'opérer une modification d'état de contrainte de la couche semi-conductrice. Le SiN a une faible absorbance à la longueur d'onde des lasers UV utilisés pour effectuer des recuits de matériau semi-conducteur. Cela permet de déposer l'énergie du faisceau laser plus directement sur l'empilement semi-conducteur, donc une plus grande efficacité de chauffe. Par « transparence », on entend une transmittance importante et de préférence supérieure à 70%.

Dans le cas d'une couche semi-conductrice 104 fine et en particulier d'épaisseur inférieure à 15 nm on peut éventuellement choisir une couche 108 donneuse de contrainte distincte non transparente au laser, par exemple une couche de TiN.

On peut également prévoir un dépôt d'une couche absorbante sur la couche donneuse de contrainte, par exemple une couche de carbone amorphe.

La couche 108 donneuse de contrainte est, par exemple, obtenue à partir d'un dépôt chimique en phase vapeur de nitrure de silicium, ce dépôt pouvant être assisté par plasma. Le document « A comparison of the mechanical stability of silicon nitride films deposited with various techniques » de Pierre Morin et al. publié dans Applied Surface Science 260 (2012) 69-72 décrit par exemple des techniques connues de dépôt d'une couche de nitrure de silicium contrainte.

Par exemple, lorsque la couche 108 donneuse de contrainte est en nitrure de silicium, son épaisseur e₃ peut être comprise entre 10 nm et 1 µm, avantageusement entre 30 nm et 200 nm.

On effectue ensuite une structuration de la couche 108 donneuse de contrainte et de la couche semi-conductrice 104 de manière à définir au moins un empilement 110 et délimiter des bords latéraux de la couche semi-conductrice 104 et de la couche 108 donneuse de contrainte. Bien qu'un seul empilement ne soit représenté sur la figure 1B cette structuration de la superposition de couches peut éventuellement conduire à la formation de plusieurs empilements distincts.

L'empilement 110 peut suivre toute sorte de motifs que l'on peut produire par les procédés de photolithographie et/ou de gravure connus. Par exemple, un motif de forme rectangulaire ou carrée ou bien une forme en L, voire une forme de disque peut être réalisé. Cette forme peut être choisie en fonction de la modification de contrainte désirée.

Pour effectuer la structuration et réaliser un ou plusieurs empilements, une gravure, par exemple à l'aide de plasma est mise en œuvre. Dans l'exemple illustré sur la figure 1B, la gravure est prolongée dans la couche 102 fusible. Une telle structuration est effectuée pour permettre ultérieurement qu'une relaxation de la couche 108 donneuse de contrainte puisse être opérée et favoriser le transfert de contrainte dans la couche semi-conductrice 104.

Pour réaliser la modification de l'état de contrainte dans la couche semi-conductrice 104, on réalise ensuite au moins un traitement thermique, en particulier un traitement thermique dit « rapide » de sorte à effectuer une fusion d'au moins une épaisseur de la couche 102 fusible.

Cette étape de fusion est transitoire et comporte ainsi le passage, de manière transitoire, d'au moins une épaisseur donnée de la couche 102 fusible d'un état solide à un état liquide. Pendant que la couche 102 fusible ou au moins ladite épaisseur de la couche fusible est dans un état liquide, la couche 108 donneuse de contrainte peut se déformer pour libérer en partie sa contrainte et par ce biais mettre en contrainte la couche semi-conductrice 104 ou plus généralement modifier la contrainte dans la couche semi-conductrice 104.

La couche 102 fusible peut être rendue liquide sur au moins une partie de son épaisseur et selon au moins une tranche. Ainsi, la couche 102 fusible n'est pas nécessairement rendue liquide sur toute son épaisseur et n'est pas nécessairement rendue liquide entièrement dans un plan parallèle au plan principal du substrat. Par « plan principal » du substrat on entend ici un plan parallèle au plan [O; x ; y] donné sur la figure 1C.

On chauffe ainsi au moins une région de la couche fusible à une température supérieure ou égale à une température de fusion du matériau.

De préférence, lorsque la couche fusible est formée d'un composé semi-conducteur également appelé alliage semi-conducteur, par exemple tel que du silicium germanium, on porte la couche 102 fusible à une température supérieure à la température de liquidus de ce composé.

Le chauffage et l'empilement 110 sont également prévus de sorte que la couche 104 semi-conductrice reste à l'état solide sur au moins une épaisseur 104a. Cette épaisseur 104a de la couche 104 conservée à l'état solide est celle qui se trouve en contact avec, ou tout au moins du côté de la couche donneuse 108. Une épaisseur 104b de la couche 104 qui se trouve en en contact avec la couche 102 peut quant à elle être éventuellement au moins partiellement rendue liquide.

Toutefois, de préférence, on conserve la couche 104 semi-conductrice à l'état solide sur toute son épaisseur durant le traitement thermique. Cela est possible notamment du fait de la composition différente entre les couches 102, 104 et en particulier de leurs différences de températures de fusion respectives ou de températures de liquidus respectives.

On prévoit le traitement thermique de préférence de sorte à conserver la couche semi-conductrice 104 à une température inférieure à sa température de fusion. Lorsque la couche semi-conductrice est formée d'un composé semi-conducteur, par exemple tel que silicium germanium, on porte la couche 104 semi-conductrice à une température de préférence inférieure à la température de solidus de ce composé.

Dans le cas où la couche fusible 102 est en Ge et la couche semi-conductrice 104 en silicium, l'empilement peut être chauffé à une température appartenant à l'intervalle entre 938°C et 1413°C pour obtenir une couche de Ge à l'état liquide sans rendre le silicium liquide. Pour une configuration avec une couche semi-conductrice 102 en silicium et la couche fusible en Si_{1-y}Ge_{y}, on vise à chauffer l'empilement préférentiellement à une température située la ligne de liquidus du diagramme de phase Si-Ge. Plus la concentration y de Germanium dans le composé Si_{1-y}Ge_{y} est importante, plus l'intervalle entre la température liquidus et la température de fusion du Si est importante. On prévoit donc dans ce cas de préférence une couche fusible 102 en Si_{1-y}Ge_{y} avec une forte concentration en Ge, par exemple supérieure à 30% ou 40 %.

Par traitement thermique « rapide » on entend ici, un traitement thermique de courte durée, typiquement inférieure à la microseconde, typiquement entre 20 et 1000 ns, de préférence inférieure à 200 ns et avantageusement avec une montée en température rapide pour permettre de revenir à un état solide et figer la contrainte dans la couche semi-conductrice 104.

Typiquement, un tel traitement thermique est réalisé à l'aide d'un laser L (figure 1C) qui permet de chauffer à des températures très élevées, très rapidement. Une exposition à un laser permet également un refroidissement rapide de l'empilement, une fois l'exposition au laser arrêtée.

La fusion de la couche 102 mise en œuvre par le biais du traitement précité permet de relaxer l'ancrage mécanique de la couche 104 semi-conductrice par rapport à son support. Il résulte de cette modification d'ancrage une modification de l'état de contrainte de la couche 104 semi-conductrice. Le retour à l'état solide de la couche 102 fusible permet ensuite de figer la structure et donc l'état de contrainte modifié. L'étape de traitement thermique conduisant à la fusion temporaire de la couche fusible 102 permet un changement de l'état de contrainte au sein de la couche 104 semi-conductrice.

La fusion peut être en particulier mise en œuvre en soumettant l'empilement 110 de couches à une seule voire à plusieurs impulsion(s) d'un faisceau laser L, et en particulier d'un laser dit « nano-seconde », c'est-à-dire avec une durée d'impulsion typiquement inférieure à 1 microseconde. L'utilisation d'un laser fonctionnant en régime impulsionnel permet de limiter le budget thermique, tout en évitant une montée globale trop importante en température du reste de l'empilement 110. La longueur d'onde du laser L, la durée d'impulsion du faisceau laser et de préférence la densité d'énergie du faisceau laser sont choisies en fonction de l'empilement 110 de couches, de sorte à permettre la fusion, au moins localement, du matériau de la couche 102 fusible tout en conservant au moins une épaisseur de la couche semi-conductrice 104 à l'état solide.

La longueur d'onde du laser peut être comprise entre 100 nm et 550 nm, et de préférence entre 250 nm et 400 nm.

La durée de la, ou de chaque, impulsion du faisceau laser peut être comprise par exemple entre 10 ns et 500 ns, et de préférence entre 100 ns et 200 ns.

A longueur d'onde donnée du laser, la densité d'énergie du faisceau laser choisie dépend de la réflectivité de l'empilement. Cette gamme peut donc être élargie et/ou modifiée en fonction de l'empilement réalisé. Selon un exemple de réalisation particulier, on peut prévoir une densité d'énergie comprise entre 0.01 et 2J/cm². L'Homme du Métier peut s'appuyer sur une combinaison d'outils de simulations par exemple tel qu'évoqué dans le document « LIAB: a FEniCS based computational tool for laser annealing simulation », de Lamagna et al., 2017 et d'outils de charactérisation physique à l'aide d'imagerie XRD (diffractométrie de rayons X), MEB (microscopie électronique à balayage), TEM (Microscopie électronique en transmission) pour déterminer les conditions précises en fonction de l'empilement choisi.

Lorsque le matériau semi-conducteur de la couche fusible 102 est un composé, la mise en œuvre d'un recuit rapide et en particulier au moyen d'un laser L permet de faire fondre ce matériau de manière rapide tout en évitant une diffusion d'éléments du composé vers la couche semi-conductrice 104. Ainsi, par exemple, lorsque le composé est du SiGe on évite une diffusion de Germanium dans la couche semi-conductrice 104, par exemple en silicium.

La couche 102 fusible étant de préférence dépourvue de dopants, le traitement thermique rapide et en particulier réalisé par laser permet de ne pas entrainer de diffusion intempestive de dopants dans la couche semi-conductrice 104.

Suite au traitement thermique et à la dernière impulsion laser émise sur l'empilement, le retour à l'état solide de la couche 102 fusible se fait rapidement typiquement dans une durée inférieure à 1 µs pour des conditions de traitement et des épaisseurs telles que dans les exemples de réalisation précités.

Durant la fusion et mise de manière transitoire dans un état liquide de la couche fusible, le support de cette dernière est de préférence conservé dans un état solide. Ainsi la couche superficielle du support sur laquelle la couche 102 fusible peut être disposée et en contact en un matériau donné ayant de préférence une température de fusion supérieure ou une température de liquidus supérieure à la température de fusion ou de liquidus dudit deuxième matériau semi-conducteur, de sorte que lors du traitement thermique rapide, ladite couche superficielle reste à l'état solide. Le cas échéant, le premier matériau semi-conducteur et le matériau donné peuvent être le même matériau. C'est le cas, par exemple, dans le cas évoqué ci-dessus d'un substrat massif en silicium pour une couche semi-conductrice en silicium.

Selon un mode avantageux, en particulier lorsque la couche fusible 102 est en Si_{1-y}Ge_{y} avec y ≤ 0.5, la couche semi-conductrice 104 dont on souhaite modifier la contrainte peut être prévue plus épaisse et par exemple au moins deux fois plus épaisse que la longueur d'absorption du laser utilisé. Cela peut permettre de contrebalancer un effet local de réflexion du laser par la couche fusible 102. La longueur d'absorption du laser peut être obtenue en considérant l'intensité du laser en fonction de la profondeur et en considérant par exemple que pour une intensité de 1/e, e étant le nombre d'Euler égal environ à 2,71828, correspondant à 37% d'intensité, ce qui correspond à 10nm (10nm a absorbé 63%). Pour le Si, la longueur d'absorption d'un laser UV (308 nm de longueur d'onde) est sensiblement égale à 10 nm, donc pour éviter un effet local de réflexion, on choisit une épaisseur de la couche de silicium 104 strictement supérieure à 20nm.

Lorsque la couche semi-conductrice 104 est prévue avec une épaisseur inférieure à 20 nm, on prévoit avantageusement une couche fusible 102 en Si_{1-y}Ge_{y} avec y cette fois supérieur à 0.5, permettant d'abaisser la température de fusion de la couche fusible 102 ce qui permet de limiter l'énergie nécessaire à apporter pour faire fondre cette couche et donc limiter l'effet local de réflexion.

Une fois la modification de contrainte mise en œuvre, on peut retirer la couche donneuse 108 de contrainte. Lorsque cette couche 108 est en nitrure de silicium un retrait par gravure, par exemple une gravure humide à l'aide de HF ou d'acide orthophosphorique ou bien une gravure plasma peut être effectuée (figure 1D).

On peut ensuite poursuivre des étapes de réalisation d'un dispositif microélectronique et/ou optoélectronique et réaliser un ou plusieurs composants au moins partiellement dans la couche semi-conductrice 104, en particulier un ou plusieurs transistors, dont la région de canal s'étend dans cette couche semi-conductrice 104.

Un procédé de modification d'état de contrainte tel que décrit précédemment peut s'appliquer à un empilement présentant un agencement différent de l'empilement 110 prévu dans l'exemple de réalisation qui vient d'être donné.

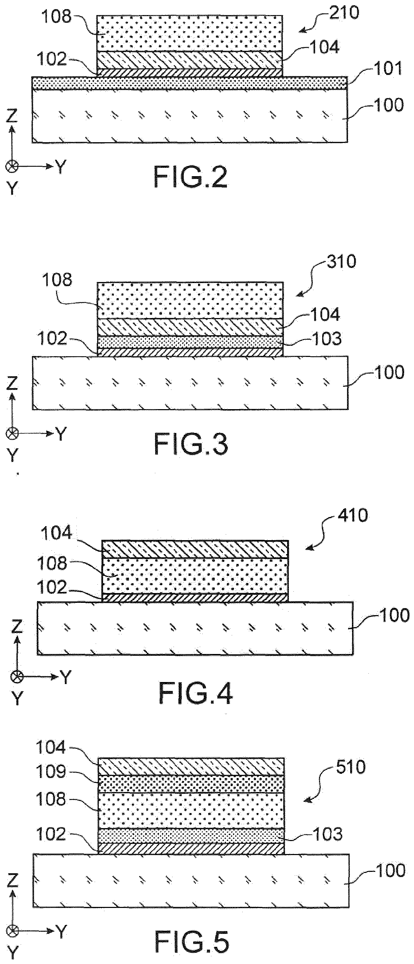

Ainsi, selon une variante de réalisation du procédé illustrée sur la figure 2, on peut effectuer le traitement thermique rapide conduisant à la modification de contrainte sur un empilement 210 comportant la couche 102 fusible, la couche 104 semi-conductrice, la couche 108 donneuse de contrainte, ainsi qu'une couche intercalaire entre le support 100 et la couche 102 fusible. Cette couche intercalaire peut être une couche isolante 101, en particulier une couche isolante d'un substrat de type semi-conducteur sur isolant, typiquement une couche d'oxyde de silicium (SiO₂) couramment appelée « BOX » pour (« burried oxide » ou « oxyde enterré »). Le BOX peut présenter une épaisseur comprise entre 10nm et 150nm, de préférence l'épaisseur du BOX est inférieure à 25nm. Plus précisément, lorsque la couche 104 présente une épaisseur inférieure ou égale à 20nm, l'épaisseur du BOX est comprise entre 10nm et 150nm et lorsque la couche 104 présente une épaisseur supérieure à 20nm, l'épaisseur du BOX est inférieure à 25nm.

Dans l'exemple de réalisation illustré sur la figure 3, une couche intercalaire est cette fois agencée entre la couche 102 fusible et la couche 104 semi-conductrice. Cette couche intercalaire peut être également une couche isolante 103, par exemple une couche d'oxyde de silicium (SiO₂). Un tel empilement est typiquement obtenu par transfert de couches. On peut par exemple rapporter sur le support 100 revêtu de la couche fusible 102, un substrat doté d'un socle semi-conducteur contenant la couche semi-conductrice 104 et revêtue de la couche intercalaire isolante 103. Puis une fois un collage effectué, on retire une partie du socle pour ne conserver que la couche semi-conductrice 104 soit par un procédé de type smartcut^{™} soit par un procédé d'amincissement utilisant une ou plusieurs étapes de CMP (« Chemical mechanical planarization »).

La couche donneuse de contrainte 108 n'est pas nécessairement agencée au-dessus de la couche semi-conductrice 104 dont on souhaite modifier la contrainte. Ainsi, dans l'exemple illustré sur la figure 4, on prévoit un empilement 410 dans lequel la couche donneuse de contrainte 108 est cette fois située entre la couche 102 fusible et la couche 104 semi-conductrice et peut être en particulier disposée sous, et en contact avec, la couche semi-conductrice 104.

Une variante d'agencement de l'exemple de réalisation précédent prévoit cette fois un empilement 510 doté d'une couche intercalaire 109, par exemple en oxyde de silicium (SiO₂), entre la couche semi-conductrice 104 dont on souhaite modifier la contrainte et la couche donneuse de contrainte 108 ici sous-jacente. Une autre couche intercalaire 103, qui peut être isolante et par exemple en oxyde de silicium (SiO₂), est également prévue, comme sur la figure 5, cette fois entre la couche 108 donneuse de contrainte 108 et la couche 102 fusible sous-jacente.

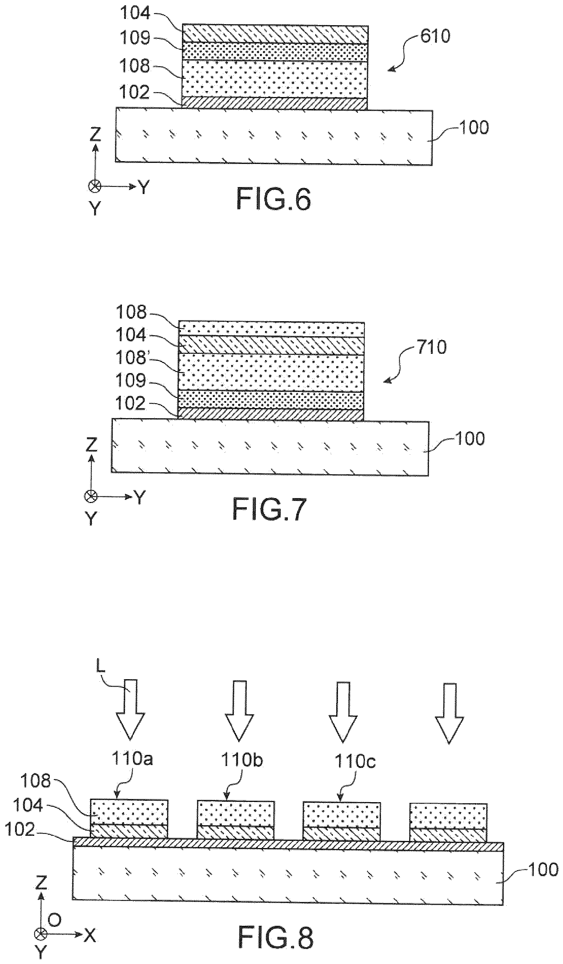

Dans une autre variante d'agencement illustrée sur la figure 6, l'empilement 610 est cette fois doté de la couche intercalaire 109, par exemple en oxyde de silicium (SiO₂), entre la couche semi-conductrice 104 et la couche 108 donneuse de contrainte, tandis que la couche 108 donneuse de contrainte est cette fois disposée sur, et en contact avec, la couche 102 fusible.

Afin notamment d'augmenter le transfert de contrainte dans la couche semi-conductrice 104, une autre variante prévoit d'introduire au moins une couche donneuse de contrainte 108' supplémentaire.

Cette couche donneuse 108' de contrainte est ainsi à base d'un matériau ayant une contrainte intrinsèque en tension ou en compression. Les couches donneuses 108, 108' de contrainte peuvent être à base de matériaux identiques, par exemple du nitrure de silicium. On peut prévoir une couche donneuse de contrainte 108 dite « supérieure » disposée sur la couche semi-conductrice 104 et avantageusement en contact avec cette dernière et une couche donneuse de contrainte 108' supplémentaire et dite « inférieure » disposée sous la couche semi-conductrice 104 et avantageusement en contact avec cette dernière. Dans l'exemple de réalisation particulier illustré sur la figure 7, l'empilement 710 comporte ainsi des couches 108, 108' donneuses de contrainte respectivement sur et sous la couche semi-conductrice 104. Hormis les couches 108, 108' précitées, l'empilement 710 comporte ici une couche intercalaire 103, par exemple en oxyde de silicium (SiO₂), entre la couche 102 fusible et la couche donneuse de contrainte 108' inférieure.

Une couche intercalaire entre la couche donneuse de contrainte 108 et la couche semi-conductrice 104 peut être éventuellement prévue dans chacune des variantes de réalisation de la présente description. Une telle couche intercalaire par exemple en oxyde de silicium (SiO₂) peut avoir typiquement une épaisseur comprise entre 1 nm et 3 nm d'épaisseur.

Une étape de traitement thermique rapide telle que décrite précédemment afin d'opérer une modification de contrainte d'une couche semi-conductrice 104 n'est pas nécessairement réalisée sur un seul empilement. En effet, une telle étape peut être réalisée sur plusieurs empilements distincts et chacun doté d'une couche 102 fusible et d'une couche semi-conductrice 104 dont on souhaite modifier la contrainte. De tels empilements peuvent être réalisés par gravure, par exemple en formant une ou plusieurs tranchées à travers une superposition de couches selon l'une ou l'autre des possibilités décrites précédemment.

Dans l'exemple illustré sur les figures 8, 9, 10, les empilements 110a, 110b, 110c, sont dotés chacun d'une couche donneuse 108 de contrainte.

La couche fusible 102 peut être conservée « pleine plaque » ou continue, comme sur la figure 8, sans que l'on réalise de motif ou que l'on grave cette dernière dans une étape ultérieure après son dépôt et en particulier lors de la gravure de l'empilement.

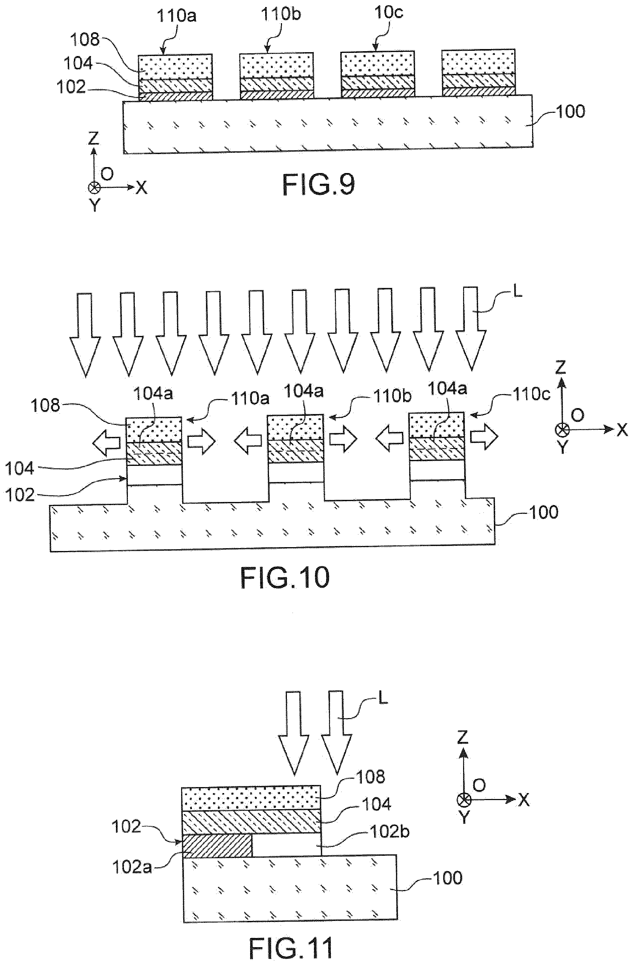

En variante (figure 9), la couche fusible 102 peut être gravée dans le prolongement de la couche semi-conductrice 109 comme cela a été décrit précédemment en liaison avec la figure 1B.

Une autre variante, prévoit cette fois une structuration des empilements 110a, 110b, 110c par gravure prolongée dans une partie de la couche située sous la couche fusible 102.

Dans l'exemple de réalisation illustré sur la figure 10, cette gravure est prolongée dans une épaisseur superficielle du support à la couche fusible et qui peut être par exemple un substrat 100 massif.

Dans l'un ou l'autre des exemples de réalisation illustrés sur les figures 8, 9, 10, les empilements 110a, 110b, 110c, obtenus par structuration peuvent être exposés successivement ou simultanément à une ou plusieurs impulsions laser L pour effectuer un traitement thermique tel que décrit précédemment. Dans chaque empilement exposé au laser L, on peut rendre liquide une épaisseur de la couche fusible 102 surmontée par la couche semi-conductrice 104 elle-même placée en regard de la couche donneuse 108 de contrainte et dont on conserve au moins une épaisseur 104a à l'état solide durant cette exposition. Là encore, on préserve à l'état solide l'épaisseur 104a ou région de la couche 104 qui se trouve du côté de la couche donneuse 108.

En fonction de la modification de contrainte souhaitée on peut chercher à rendre les motifs réalisés dans la couche fusible 102 entièrement liquides.

L'étape de traitement thermique rapide peut être en variante prévue de sorte à rendre une épaisseur localisée de la couche fusible 102 dans un état liquide, c'est à dire sans rendre nécessairement cette couche fusible liquide entièrement dans un plan parallèle au plan principal de cette couche. Par « plan principal » d'une couche on entend ici et dans toute la description un plan parallèle au plan [O; x ; y ]. Ainsi, dans l'exemple de réalisation illustré sur la figure 11, on réalise la fusion à l'aide d'un laser L d'une épaisseur 102b de la couche fusible surmontée par la couche semi-conductrice 104 elle-même placée en regard de la couche donneuse de contrainte, tandis qu'une zone 102a de la couche fusible juxtaposée à cette épaisseur 102a n'est pas exposée au laser L, afin de la conserver dans un état solide.

Cela peut être réalisé par exemple en formant une couche réflective au laser sur la zone 102a que l'on souhaite conserver solide.

Un traitement thermique rapide par laser tel que décrit précédemment peut être réalisé pour mettre en œuvre des modifications de contrainte de différents types sur différentes régions semi-conductrices d'un même support. Ainsi, une mise en tension d'une région semi-conductrice et une mise en compression d'une autre région semi-conductrice, peuvent être réalisées sur le même support. Selon une autre possibilité, on peut mettre en compression ou en tension une région semi-conductrice et réaliser une relaxation d'une autre région semi-conductrice, ce sur le même support. Un tel type de procédé peut être réalisé par exemple dans le cas d'une co-intégration de transistors de type P et de type N dont les régions de canal ont des contraintes opposées.

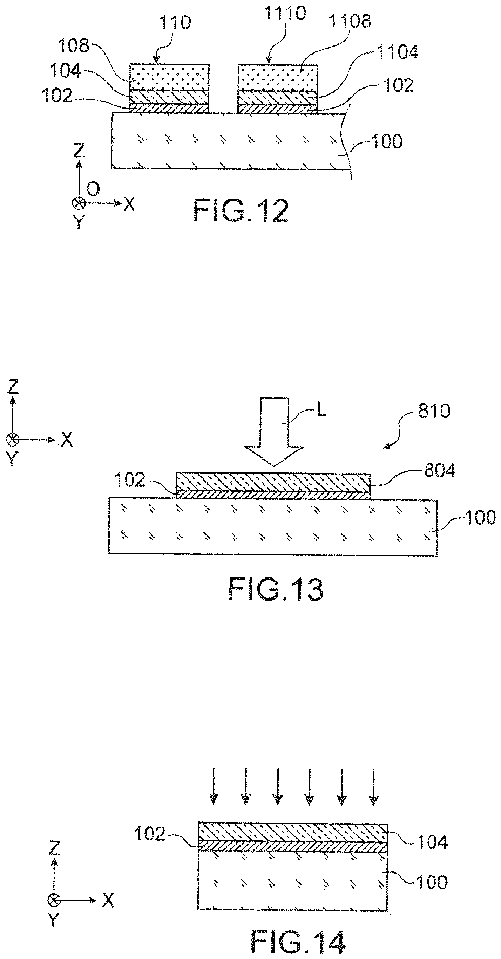

Ainsi, par exemple, on peut également appliquer un traitement thermique rapide tel que décrit précédemment sur des empilements 110, 1110 distincts comme représentés sur la figure 12. Ces empilements 110, 1110 sont dotés de couches 108, 1108 donneuses de contrainte différentes c'est-à-dire ayant des contraintes intrinsèques différentes et qui peuvent être opposées. On peut en particulier prévoir un premier empilement 110 avec la couche fusible 102, la couche semi-conductrice 104 et la couche donneuse de contrainte 108, typiquement en nitrure de silicium et ayant une contrainte intrinsèque donnée, par exemple une contrainte en tension. Un deuxième empilement 1110 est doté quant à lui d'une deuxième couche donneuse de contrainte 1108, typiquement en nitrure de silicium, ayant une contrainte intrinsèque de type opposé à celui de la première couche 108, par exemple une contrainte intrinsèque en compression. La deuxième couche donneuse de contrainte 1108 est agencée sur une portion semi-conductrice notée 1104 qui peut être en un matériau distinct de celui de la couche semi-conductrice 104 ou qui peut être issue initialement de la même couche semi-conductrice 104, mais séparée de cette dernière par une tranchée par exemple réalisée par gravure.

Dans le cas particulier, donné à titre d'exemple, où la première couche donneuse 108 de contrainte est dotée d'une contrainte intrinsèque en tension tandis que la deuxième couche 1108 donneuse de contrainte a une contrainte intrinsèque en compression, on peut mettre les couches semi-conductrices 104, 1104 respectivement en compression et en tension.

D'autres couples de matériaux que ceux évoqués dans les exemples décrits précédemment peuvent être employés respectivement pour la couche 104 semi-conductrice et la couche fusible 102.

Ainsi, il est également possible par exemple de prévoir la couche 104 semi-conductrice et la couche 102 fusible chacune en silicium-germanium mais avec des concentrations en Germanium respectives différentes. La concentration en pourcentage atomique du germanium dans le deuxième matériau semi-conducteur (i.e. dans la couche 102 fusible) est dans ce cas supérieure à la concentration en pourcentage atomique du germanium dans le premier matériau semi-conducteur (i.e. dans la couche 104 semi-conductrice) afin de permettre une fusion sélective de la couche 102 fusible lors de l'étape de traitement thermique via laser, c'est à dire sans faire fondre la couche semi-conductrice 104 ou tout au moins en conservant au moins une épaisseur solide dans cette dernière. Comme indiqué précédemment, on conserve solide au moins une épaisseur de la couche semi-conductrice 104 qui se trouve à proximité et/ou en contact avec la couche 108 donneuse de contrainte ou du côté de la couche 108 donneuse de contrainte.

Afin de faciliter la fusion de la couche 102 fusible tout en empêchant celle de la couche 104 de la couche semi-conductrice ou en empêchant celle de la couche 104 de la couche semi-conductrice sur toute son épaisseur, il est possible de choisir des matériaux semi-conducteurs adaptés en fonction des températures permettant leur mise sous état liquide. Ainsi, de préférence, la température de fusion de la couche 102 fusible est inférieure à la température de fusion de la couche 104 semi-conductrice voire à la température du solidus de la couche 104 semi-conductrice. La température du liquidus de la couche 102 fusible est prévue inférieure à la température de fusion de la couche 104 semi-conductrice voire à la température du solidus de la couche 104 semi-conductrice.

Selon un autre exemple, il peut être prévu que le premier matériau semi-conducteur (de la couche 102 fusible) est du germanium tandis que le deuxième matériau semi-conducteur (de la couche 104 semi-conductrice) est à base de germanium et d'étain.

Une autre variante de réalisation prévoit cette fois de réaliser l'étape de traitement thermique conduisant à la mise transitoire sous état liquide d'une couche fusible 102, sur un empilement 810 dépourvu de couche donneuse de contrainte telle que décrite précédemment. Un tel empilement 810, illustré sur la figure 13, est cette fois doté d'une couche semi-conductrice 804 à base d'un premier matériau semi-conducteur contraint en tension ou en compression.

La mise en contrainte de la couche 804 peut avoir été effectuée préalablement, par exemple en utilisant un matériau semi-conducteur ayant un paramètre de maille différent de celui de la couche semi-conductrice 804.

Selon un exemple, une couche 804 semi-conductrice en état de contrainte en compression avant la modification de son état de contrainte, peut être obtenue de la manière suivante. Une croissance, par épitaxie sur un support 100 de silicium, d'une première couche de silicium-germanium est tout d'abord réalisée. Cette première couche de silicium-germanium présente une concentration de germanium strictement supérieure à 25%, par exemple égale à 50%, et une épaisseur comprise entre 5 nm et 30 nm. Cette première couche de silicium-germanium permet de former la couche 102 fusible. Ensuite une deuxième couche de silicium-germanium est formée sur la première couche de silicium-germanium, par exemple par croissance par épitaxie sur la première couche de silicium-germanium. Cette deuxième couche de silicium-germanium présente une concentration de germanium inférieure à celle de la première couche et par exemple égale à 10% et une épaisseur comprise par exemple entre 10 nm et 30 nm. Cette deuxième couche de silicium-germanium permet de former la couche 804 semi-conductrice. Une structuration typiquement par photolithographie et gravure de la deuxième couche de silicium-germanium et éventuellement la première couche de silicium-germanium permet de délimiter l'empilement 810.

Selon un autre exemple, une couche 804 semi-conductrice est en état de contrainte en tension avant la modification de son état de contrainte. Une telle couche 804 peut être obtenue de la manière suivante. On réalise une croissance par épitaxie sur un support 100, d'une couche de silicium-germanium relaxée. Cette couche de silicium-germanium présente une concentration en germanium comprise entre 15% et 30%. Cette couche de silicium-germanium relaxée permet de former la couche 102 fusible ou une couche de support pour le matériau de la couche 102 fusible qui peut être déposée sur la couche de silicium-germanium relaxée afin de former une couche fusible 102, contrainte. Ensuite, sur la couche 102 fusible, on forme une couche 804 semi-conductrice, par exemple par croissance par épitaxie. La couche 804 semi-conductrice peut être en silicium, et présenter une épaisseur comprise par exemple entre 10 nm et 30 nm. Une structuration de la couche semi-conductrice 804 et éventuellement de la couche fusible 802 par gravure est ensuite réalisée.

On expose ensuite l'empilement 810 à une ou plusieurs impulsions laser L, suivant une étape de traitement thermique rapide telle que décrite précédemment. La modification de contrainte induite par le traitement thermique et la mise transitoire sous état liquide de la couche fusible 102, peut permettre par exemple d'effectuer une relaxation de la couche 804 semi-conductrice.

Selon une réalisation particulière du procédé, afin de favoriser la fusion sélective de la couche fusible 102 lors du traitement thermique rapide décrit précédemment, on peut prévoir cette couche à base d'un matériau semi-conducteur amorphe ou rendu amorphe. Le premier matériau semi-conducteur formant la couche 104 semi-conductrice est alors cristallin, par exemple du silicium cristallin et le deuxième matériau semi-conducteur formant la couche 102 fusible est amorphe, par exemple du silicium ou du silicium-germanium amorphe. On peut en effet abaisser la température à laquelle le deuxième matériau semi-conducteur passe à l'état liquide en le faisant passer de sa forme cristalline à sa forme amorphe. Le silicium-germanium amorphe présente en effet une température de liquidus inférieure à celle du silicium-germanium cristallin, la température du liquidus du silicium-germanium cristallin étant inférieure à la température de fusion du silicium cristallin. On abaisse d'autant plus la température à laquelle le deuxième matériau semi-conducteur passe à l'état liquide que la concentration de germanium de la couche 102 fusible de silicium-germanium est importante.

Le deuxième matériau semi-conducteur formant la couche 102 fusible peut être rendu amorphe par implantation ionique. Une telle implantation est réalisée avant l'étape de traitement thermique conduisant à la fusion de la couche 102 fusible. Comme cela est illustré sur la figure 14, une telle étape peut être réalisée avant dépôt de la couche donneuse de contrainte 108. En variante on peut réaliser cette étape d'amorphisation après dépôt de la couche de contrainte.

L'implantation ionique est effectuée de manière à rendre amorphe au moins une épaisseur de la couche fusible 102 avec un profil d'implantation tel que la couche semi-conductrice 104 conserve sa structure cristalline.

Les conditions d'implantation pour l'amorphisation d'au moins une épaisseur de la couche fusible 102 semi-conductrice peuvent être définies à l'aide d'un outil de simulation tel que par exemple un logiciel de type C-TRIM (CTRIM pour « Crystal Transport of Ions in Matter ») utilisant des algorithmes de Monte Carlo.

Pour une espèce implantée donnée, l'énergie d'implantation est calculée de manière à placer un pic de défauts, autrement dit un maximum de déplacement d'atomes de la matrice au niveau de la couche fusible 102. De préférence l'implantation est réalisée avec un angle permettant une canalisation des ions dans la structure cristalline de la couche 104 afin de préserver au maximum cette structure. Cela est typiquement obtenu avec un angle de 0 degrés par rapport à une normale au plan principal du substrat pour un substrat type 001.

Pour le cas spécifique d'une couche 104 en Si et d'une couche 108 en SiGe, des ions de Si peuvent être utilisés par exemple. La dose implantée est calculée de manière à engendrer l'amorphisation de la couche de SiGe. Une gamme typique de dose pour le SiGe peuvent se situer entre 1.5^{e}14 et 3^{e}14 at/cm2.

L'implantation amorphisante peut être réalisée à l'aide d'une espèce inerte, non-dopante pour le matériau semi-conducteur implanté, par exemple des atomes de Si. Par « espèce inerte » on entend ici une espèce qui n'est pas destinée à modifier les propriétés électriques du matériau semi-conducteur implanté. Par exemple on implante une couche fusible 102 en SiGe d'épaisseur comprise par exemple entre 5 et 50 nm et en particulier entre 5 et 30 nm avec une concentration en Germanium prévue entre 20 et 70%, de préférence de 25-60%, surmontée d'une couche 104 de silicium d'épaisseur comprise par exemple entre 5 et 50 nm et en particulier entre 5 et 20 nm.

Une structure obtenue au terme d'un procédé de modification de contrainte tel que décrit précédemment présente des applications dans les domaines de la microélectronique et/ou de la photonique.

En particulier, une structure obtenue au terme du procédé de modification peut être utilisée pour former au moins un transistor dont la région de canal a un niveau de contrainte adapté en fonction du type de porteurs de charge qu'il est destiné à véhiculer. L'une ou l'autre des séquences d'étapes décrites précédemment et permettant une modification de contrainte d'au moins une couche semi-conductrice peut être ainsi intégrée à un procédé de fabrication d'au moins un composant microélectronique, en particulier d'au moins un transistor.

Une fois avoir effectué un procédé de modification de contrainte, on peut partir d'une structure par exemple telle que décrite en liaison avec la figure 1D pour fabriquer le transistor.

Ainsi, en partant de l'empilement comportant successivement le substrat 100 servant de support, la couche 102 fusible, la couche 104 semi-conductrice, le procédé de fabrication d'un transistor T peut comporter ensuite des étapes de formation d'un diélectrique 1501 de grille et d'une électrode 1503 de grille. Cela peut être réalisé par dépôts successifs et gravure(s) d'une couche de diélectrique de grille, par exemple en SiO₂ et d'au moins une couche de matériau de grille, par exemple en polysilicium.

Des espaceurs 1505 isolants peuvent être également formés de part et d'autre de flancs latéraux de l'électrode de grille par exemple par dépôt d'une couche à base de nitrure de silicium puis gravure anisotrope.

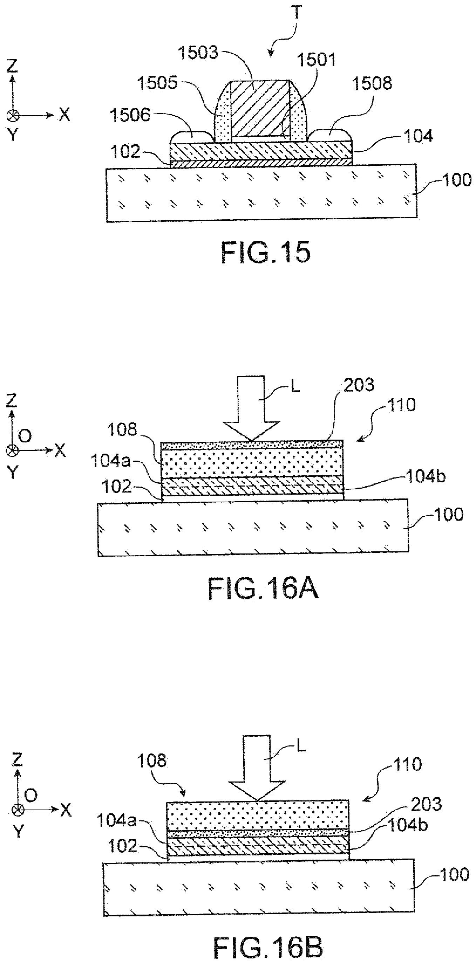

Des étapes de formation de régions de source 1506 et de drain 1508 sont également effectuées. Une méthode typique de réalisation de ces régions comprend une croissance par épitaxie de blocs de matériau semi-conducteur sur la couche semi-conductrice 104. Ces blocs semi-conducteurs peuvent être dopés et des zones de contacts peuvent être réalisées par exemple par siliciuration de ces blocs semi-conducteurs (figure 15).

Ainsi, il est possible de bénéficier d'une couche 104 semi-conductrice, contrainte avec un niveau de contrainte adapté pour former une région de canal de transistor T.

Dans une variante de réalisation illustrée sur les figures 16A et 16B, on peut prévoir d'intégrer dans la superposition de couches que l'on soumet à un rayonnement laser pour réaliser la fusion transitoire d'une couche fusible 102, une couche d'absorption 203 de l'énergie du laser L. Une telle couche 203 est prévue en termes d'épaisseur et de composition pour absorber et transférer la chaleur par conduction afin d'éviter une réflexion de photons par la couche fusible 102. Cette couche d'absorption 203 peut être en particulier disposée sur la partie supérieure de l'empilement, par exemple sur la couche donneuse 108 de contrainte (figure 16A) ou bien peut être agencée entre la couche donneuse 108 de contrainte et la couche 104 dont on souhaite modifier la contrainte. Par exemple, la couche d'absorption 203 peut être en carbone amorphe ou en silicium amorphe ou à base de silicium polycristallin dans le cas de la figure 16A où elle est située sur la couche donneuse 108 de contrainte.

## Revendications

1. Procédé de modification de l'état de contrainte d'au moins une couche (104) semi-conductrice comprenant des étapes de : a) réalisation sur un support (100) d'au moins un empilement (110, 110a, 110b 110c, 210, 310, 410, 510, 610, 710) de couches comportant ladite couche (104) semi-conductrice en un premier matériau semi-conducteur et une couche (102) dite « fusible », ladite couche (102) fusible étant prévue à base d'un deuxième matériau semi-conducteur, distinct du premier matériau semi-conducteur, ladite couche (102) fusible étant dépourvue de dopants et agencée entre la couche (104) semi-conductrice et le support (100), ladite superposition de couches comprenant en outre une couche (108) donneuse de contrainte, la couche (108) donneuse de contrainte étant à base d'un matériau présentant une contrainte intrinsèque en tension, la réalisation dudit empilement comprenant des étapes de :
- formation de la superposition de couches sur ledit support (102) comprenant ladite couche (102) fusible, ladite couche (104) semi-conductrice, la couche (108) donneuse de contrainte
- gravure de ladite superposition de couches de sorte à définir ledit au moins un empilement et délimiter des bords latéraux de la couche (104) semi-conductrice, la gravure de ladite superposition de couches étant réalisée de sorte à délimiter des bords latéraux de la couche (108) donneuse de contrainte à base d'un matériau présentant une contrainte intrinsèque en tension,
le procédé comprenant en outre à partir de ladite superposition de couches, la formation sur ledit support (100) d'un autre empilement (1110) surmonté d'une autre couche (1108) donneuse de contrainte de contrainte à base d'un matériau présentant une contrainte intrinsèque en compression,
puis,
b) traitement thermique rapide à l'aide d'un laser (L), de la couche (102) fusible dans ledit empilement, de sorte à provoquer un passage transitoire d'au moins une épaisseur de la couche (102) fusible d'un état solide à un état liquide tout en conservant au moins une épaisseur (E) de la couche (104) semi-conductrice à l'état solide.

2. Procédé selon la revendication 1, dans lequel dans ladite superposition de couches :
la couche (108) donneuse de contrainte est agencée entre la couche (102) fusible et la couche (104) semi-conductrice.

3. Procédé selon la revendication 1, dans lequel la couche (108) donneuse de contrainte est disposée au-dessus de la couche (104) semi-conductrice et dans lequel la superposition de couches comporte une couche (108') additionnelle donneuse de contrainte disposée au-dessous de la couche (104) semi-conductrice.

4. Procédé selon l'une des revendications 1 à 3, le deuxième matériau semi-conducteur a une température de fusion ou de liquidus inférieure à la température de fusion ou de liquidus dudit premier matériau semi-conducteur.

5. Procédé selon l'une des revendications 1 à 4, dans lequel la couche (102) fusible est disposée sur et en contact d'une couche superficielle dudit support en un matériau donné ayant une température de fusion ou de liquidus supérieure à la température de fusion ou de liquidus dudit deuxième matériau semi-conducteur, de sorte que lors du traitement thermique rapide, ladite couche superficielle reste à l'état solide.

6. Procédé selon l'une des revendications 1 à 5, dans lequel le support (100) est un substrat massif semi-conducteur, la couche (102) fusible étant disposée sur le substrat massif semi-conducteur ou dans lequel la couche (102) fusible est disposée sur une couche isolante (101), en particulier en oxyde de silicium d'un substrat de type semi-conducteur sur isolant.

7. Procédé selon l'une des revendications précédentes dans lequel dans ledit empilement :
- ledit premier matériau semi-conducteur est du silicium et ledit deuxième matériau semi-conducteur du silicium-germanium ou du germanium, ou
- ledit premier matériau semi-conducteur est du silicium-germanium et le deuxième matériau semi-conducteur du silicium-germanium, de concentration en pourcentage atomique du germanium supérieure à la concentration en pourcentage atomique du germanium du premier matériau, ou
- le premier matériau est formé de germanium et le deuxième matériau est formé de germanium-étain.

8. Procédé selon l'une des revendications précédentes dans lequel dans ledit empilement : le premier matériau semi-conducteur est cristallin, le deuxième matériau semi-conducteur est amorphe.

9. Procédé selon l'une des revendications précédentes : dans lequel dans ledit empilement, ledit premier matériau semi-conducteur est cristallin, la réalisation dudit empilement comprenant au moins une implantation ionique de sorte à rendre amorphe ledit matériau de la couche (102) fusible.

10. Procédé selon l'une quelconque des revendications précédentes, l'étape de traitement thermique étant effectuée à l'aide d'un laser par émission d'une ou de plusieurs impulsions laser successives, de durée d'impulsion inférieure à une microseconde et de préférence comprise entre 10 ns et 1000 ns, avantageusement entre 20 ns et 500 ns, le laser ayant une longueur d'onde typiquement comprise entre 100 nm et 550 nm et de préférence entre 250 nm et 400 nm.

11. Procédé selon l'une des revendications précédentes, le traitement thermique étant prévu de sorte à :
- chauffer ladite épaisseur de la couche (102) fusible à une température supérieure ou égale à une température de fusion du deuxième matériau semi-conducteur et supérieure ou égale à une température du liquidus du matériau de la couche (102) fusible lorsque le deuxième matériau semi-conducteur est un composé semi-conducteur, tout en conservant la couche (104) semi-conductrice à une température inférieure à une température de fusion du premier matériau semi-conducteur et inférieure à une température du solidus du premier matériau lorsque le premier matériau est un autre composé semi-conducteur.

12. Procédé de fabrication d'un transistor comprenant la mise en œuvre d'un procédé de modification selon l'une quelconque des revendications précédentes, le transistor ayant une région de canal réalisée dans ladite couche (104) semi-conductrice.

13. Procédé selon l'une des revendications 1 à 12, dans lequel une couche amorphe (103, 108) est agencée entre la couche (102) fusible et la couche (104) semi-conductrice.

14. Procédé selon la revendication 13, dans lequel la couche amorphe (103, 108) est une couche isolante, en particulier une couche d'oxyde de silicium ou de nitrure de silicium.

15. Procédé selon l'une des revendications 13 ou 14, dans lequel la couche amorphe est la couche donneuse (108) de contrainte.
